# FASCICULE DE BREVET EUROPEEN

(11) **EP 1 966 885 B1**
(45) Date de publication et mention de la délivrance du brevet: **13.02.2013**
(21) Numéro de dépôt: 06847118.4
(22) Date de dépôt: 22.12.2006
(51) Int. Cl.: H03F 3/45

(54) **PROCEDE ET DISPOSITIF DE REGLAGE OU DE CALAGE D' UN DISPOSITIF ELECTRONIQUE**
VERFAHREN UND VORRICHTUNG ZUR ANPASSUNG ODER EINSTELLUNG EINER ELEKTRONISCHEN VORRICHTUNG
METHOD AND DEVICE FOR ADJUSTING OR SETTING AN ELECTRONIC DEVICE

(30) Priorité: 27.12.2005 FR 0513366
(43) Date de publication de la demande: 10.09.2008
(73) Titulaire: UNIVERSITE JOSEPH FOURIER, F-34000 Saint-Martin D'Heres (FR); Centre National de la Recherche Scientifique (CNRS), 75016 Paris (FR)
(72) Inventeur: DZAHINI, Daniel Kwami, F-38130 Echirolles (FR)
(74) Mandataire: Dossmann, Gérard
(86) Numéro de dépôt international: PCT/FR2006/002847
(87) Numéro de publication internationale: WO 2007/074231

(56) Documents cités:
- EP-A- 0 118 178
- EP-A- 0 161 215
- WO-A-02/27942
- US-B1- 6 498 530

## Description

La présente invention concerne un procédé et un dispositif de réglage ou de calage d'un dispositif électronique.

L'offset, c'est-à-dire la différence, l'écart ou le décalage entre la valeur ou l'état des signaux aux sorties des dispositifs électroniques par rapport à la valeur ou l'état qu'ils devraient avoir idéalement, constitue une préoccupation importante. Cette préoccupation concerne notamment les dispositifs électroniques analogiques, tels que les comparateurs de tension ou de courant, ainsi que les amplificateurs de tension ou de courant.

Pour réduire l'offset des comparateurs, il est connu de mettre en cascade plusieurs étages successifs d'amplificateurs, présentant des gains de plus en plus grands. Ces étages sont reliés via des capacités et le signal de compensation d'offset est obtenu en court-circuitant temporairement les entrées / sorties correspondantes de chaque étage. Malheureusement, ce montage nécessite plusieurs opérations de court-circuitage qui augmentent le délai de sortie des résultats de comparaison.

Un autre montage de comparateurs à offset relativement faible consiste à utiliser un étage de pré-amplification de large bande et de faible offset, suivi par un étage de bascule.

Un autre montage de comparateurs réduisant la dispersion d'offset consiste à utiliser plusieurs étages de pré-amplification soumis à un pont résistif de moyennage reliant les sorties de ces étages entre elles.

Dans tous les montages ci-dessus, les offsets des étages à bascules restent ce qu'ils sont dans les chaînes de comparaison et les problèmes de consommation de courant subsistent.

Conformément à ce qui précède, les documents US-A-6 498 530, WO-A-02/27942, EP-A-0 161 215 et EP-A-0 118 178 proposent des solutions qui mettent en oeuvre des tensions pour faire varier et caler la tension aux bornes de condensateurs de réglage.

La présente invention a pour but de réduire l'offset et de réduire la consommation de courant de dispositifs électroniques.

La présente invention a tout d'abord pour objet un dispositif de réglage ou de calage d'un dispositif électronique présentant au moins une entrée d'au moins un signal d'entrée extérieur et au moins une sortie de signal de sortie, la valeur ou l'état du signal de sortie étant une fonction de la valeur ou de l'état dudit au moins un signal d'entrée, comprenant un circuit à mémoire de la valeur d'un signal de réglage, relié à une entrée de réglage du dispositif électronique ; un circuit d'incrémentation / décrémentation de ladite valeur de réglage stockée dans ledit circuit à mémoire ; et un circuit de commutation pour momentanément commuter ladite au moins une entrée du dispositif électronique à un état prédéterminé et relier ladite sortiedu dispositif électronique audit circuit à mémoire via ledit circuit d'incrémentation / décrémentation ; ledit circuit d'incrémentation / décrémentation étant adapté pour régler la valeur dudit signal de réglage de telle sorte que, quand ladite au moins une entrée du dispositif électronique est commutée vers ledit état prédéterminé, la valeur ou l'état dudit signal de sortie tende vers ou atteigne une valeur prédéterminée ou un état prédéterminé.

Selon l'invention, ledit circuit d'incrémentation /décrémentation comprend une pompe de charge dont les éléments opposés sont reliés à ladite sortie de signal du dispositif électronique et à une sortie complémentaire de cette dernière et dont le point commun est relié à ladite entrée de réglage du dispositif électronique et que ledit circuit à mémoire comprend un condensateur relié d'une part à une masse et d'autre part audit point commun de ladite pompe de charge.

Selon l'invention, le dispositif électronique présente de préférence au moins deux entrées de signaux d'entrée extérieurs et que ledit circuit de commutation est adapté pour commuter lesdites entrées du dispositif électronique à un état prédéterminé l'une par rapport à l'autre.

Selon une variante de l'invention, le dispositif électronique peut avantageusement être un comparateur.

Selon l'invention, ledit comparateur peut avantageusement comprendre un pré-amplificateur suivi d'une bascule, ledit signal de réglage étant délivré à une entrée de réglage du pré-amplificateur.

La présente invention a également pour objet un procédé de réglage ou de calage d'un dispositif électronique présentant au moins une entrée d'au moins un signal d'entrée extérieur et au moins une sortie de signal de sortie la valeur du signal de sortie étant une fonction de la valeur ou de l'état dudit au moins un signal d'entrée.

Selon l'invention, ce procédé consiste, pendant au moins une phase de réglage :
à commuter ladite au moins une entrée du dispositif électronique dans un état prédéterminé ;
à régler la valeur d'un signal de réglage du dispositif électronique par l'intermédiaire d'une pompe de charge de telle sorte que la valeur ou l'état dudit signal de sortie tendent vers ou atteignent une valeur prédéterminée ou un état prédéterminé ;
et à mémoriser la valeur réglée dudit signal de réglage, représentée par la charge d'un condensateur.

Le procédé selon l'invention consiste en outre, après ladite phase de réglage, à soumettre le dispositif électronique à ladite valeur réglée dudit signal de réglage.

Selon l'invention, le procédé peut avantageusement consister à commuter au moins deux entrées de signaux d'entrée extérieurs du dispositif électronique dans un état prédéterminé l'une par rapport à l'autre.

Selon l'invention, le procédé peut avantageusement consister à court-circuiter lesdites entrées du dispositif électronique et à régler la valeur dudit signal de réglage de telle sorte que la valeur ou l'état dudit signal de sortie tende vers ou atteigne un seuil prédéterminé.

Selon l'invention, le procédé peut avantageusement consister consiste à court-circuiter lesdites entrées du dispositif électronique et à régler la valeur dudit signal de réglage de telle sorte que la valeur ou l'état dudit signal de sortie tende vers ou atteigne un seuil de commutation.

Selon l'invention, la charge dudit condensateur est de préférence réglée par une pompe de charge dont les éléments opposés sont reliés à ladite sortie de signal du dispositif électronique et à une sortie complémentaire de cette dernière.

D'une manière générale, selon la présente invention, l'incrémentation/ décrémentation de la tension du condensateur de réglage prévu est réalisée par un courant, ce courant étant issu du point commun d'une pompe de charge soumise au signal de sortie du dispositif électronique qu'il s'agit de régler ou de caler.

La présente invention sera mieux comprise à l'étude d'un dispositif de réglage ou de calage d'un dispositif électronique et de son mode de fonctionnement, décrits à titre d'exemples non limitatifs et illustrés par le dessin annexé sur lequel :
- La figure 1 représente un schéma électronique général de la présente invention ;
- Et la figure 2 représente un schéma électronique d'une application particulière de la présente invention.

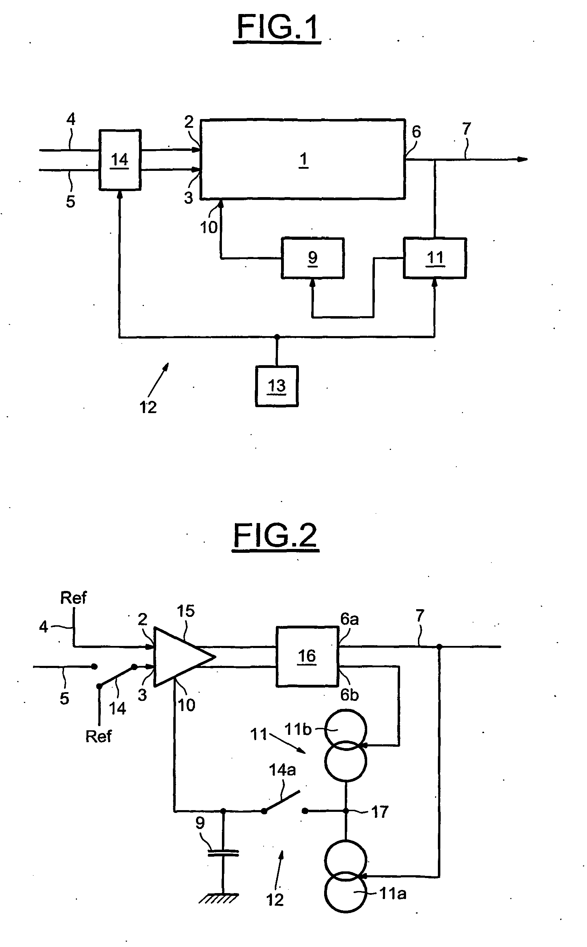

En se reportant à la figure 1, on a représenté un dispositif électronique 1 qui comprend deux entrées 2 et 3 de signaux extérieurs reliées à des lignes extérieures 4 et 5 et une sortie 6 de signal de sortie reliée à une ligne extérieure 7 de sortie de signal. La valeur ou l'état du signal de sortie est une fonction des valeurs ou des états des signaux d'entrée,

A ce dispositif 1 est associé un dispositif de réglage ou de calage 8 qui comprend un circuit 9 à mémoire de la valeur d'un signal de réglage, qui est relié à une entrée 10 de réglage ou de calage du dispositif électronique 1, un circuit 11 d'incrémentation /décrémentation, qui est relié d'une part à la sortie 6 du dispositif électronique 1 et au circuit à mémoire 9, et un circuit de commutation 12, qui comprend un circuit d'horloge 13 relié à un commutateur 14 monté sur les lignes 4 et 5 et relié à une entrée 15 d'activation du circuit 11 d' incrémentation / décrémentation.

Lors d'une phase de réglage ou de calage, le circuit d'horloge 13 délivre un signal qui active momentanément le circuit 11 d'incrémentation / décrémentation et le commutateur 14.

Le commutateur 14 place alors les entrées 2 et 3 du dispositif électronique 1 à un état prédéterminé de référence l'une par rapport à l'autre et la sortie 6 du dispositif électronique 1 est alors reliée au circuit à mémoire 9 via le circuit 11 d'incrémentation / décrémentation 11.

Le circuit d'incrémentation / décrémentation 11 est adapté pour régler, dans le circuit à mémoire 9, la valeur du signal de réglage. Pour cela, la valeur modifiée du signal de réglage est délivrée au dispositif électronique 1 qui applique sa fonction intrinsèque entre ses sorties commutées 2 et 3 et sa sortie 6. Ce signal de sortie est délivré au circuit 11 d'incrémentation / décrémentation 11 qui modifie le signal de réglage délivré au dispositif électronique 1. Cette boucle de détermination de la valeur de réglage s'exécute de telle sorte que la valeur ou l'état du signal de sortie délivré à la sortie 6 du dispositif électronique 1 tende vers ou atteigne une valeur prédéterminée idéale ou un état prédéterminé idéal.

Au bout d'une durée prédéterminée fixée par le circuit d'horloge 13, fixant la fin de la phase de réglage ou de calage, le circuit d'horloge 13 re-commute le commutateur 14 à sa position initiale et désactive le circuit d'incrémentation / décrémentation 11. La valeur finale du signal de réglage, à la fin de la phase de réglage, est stockée dans le circuit à mémoire 9 pour être délivrée au dispositif électronique 1.

A la suite de ladite phase de réglage, le dispositif électronique 1 applique sa fonction intrinsèque, entre ses entrées 2 et 3 reliées aux lignes extérieures 4 et 5 et sa sortie 6 reliée à la ligne de sortie 7, en étant soumis à la valeur du signal de réglage stockée dans le circuit à mémoire 9, qui constitue un facteur de réduction de l'offset du dispositif électronique 1.

Le circuit d'horloge 13 est adapté pour reproduire la phase de réglage décrite plus haut, par exemple selon des écarts de temps prédéterminés.

En se reportant à la figure 2, on va maintenant décrire un exemple d'application des dispositions de la figure 1, à un dispositif électronique 1 constituant un comparateur qui compare les valeurs des signaux issus des lignes 4 et 5 et délivre à sa sortie un signal de changement d'état correspondant à cette comparaison.

Ce comparateur 1 comprend un pré-amplificateur 15 présentant les entrées 2 et 3, dont par exemple l'entrée 2 est reliée à un signal de référence, par exemple à une masse, par la ligne 4 et dont l'entrée 3 est reliée à un signal extérieur d'entrée par la ligne 6.

A la suite du pré-amplificateur 15, le comparateur 1 comprend une bascule 16 présentant une sortie 6a et une sortie 6b, l'une de ces sortie correspondant à la sortie 6 pour délivrer un signal de sortie sur la ligne 7. Par rapport à un seuil de commutation correspondant à la comparaison des signaux issus des lignes d'entrée 4 et 5, la sortie 6a délivre un signal Q et la sortie 6b délivre un signal inverse Q Barre.

Le dispositif de réglage ou de calage 8 comprend un condensateur 9 à titre de circuit à mémoire et une pompe de charge 11 à titre de circuit d'incrémentation / décrémentation, ainsi qu'un commutateur 14 adapté pour commuter l'entrée 3 soit vers la ligne 5 soit vers un signal de référence, en particulier une masse, et un interrupteur 14a, à titre de circuit de commutation. Le circuit d'horloge 13 est relié au commutateur 14 et à l'interrupteur 14a.

Plus en détail, l'une des bornes du condensateur 9 est reliée à une masse et son autre borne est reliée d'une part au point commun 17 de la pompe de charge 11 via l'interrupteur 14a et d'autre part à une entrée de réglage ou de calage 10 du pré-amplificateur 15. Les sorties 6a et 6b de la bascule 16 sont respectivement reliées aux deux éléments opposés 11a et 11b de la pompe de charge 11. Selon une variante, la sortie 6a du dispositif électronique 16 pourrait être reliée à l'élément 11b de la pompe de charge 11 au travers d'un circuit inverseur.

Lors d'une phase de réglage ou de calage, le circuit d'horloge 13 délivre un signal qui momentanément active le commutateur 14 de façon à court-circuiter la ligne 5 et à relier l'entrée 3 du pré-amplificateur 15 à la référence correspondante et qui momentanément active l'interrupteur 14a vers son état fermé de façon à relier le point commun 17 de la pompe de charge 11 au condensateur 9 et donc à l'entrée de réglage 10 du pré-amplificateur 15.

Dès que la phase de réglage ou de calage est enclenchée, la pompe de charge 11 délivre au condensateur 9, par son point commun 17, un signal de charge ou de décharge de ce condensateur en fonction de l'état des sorties 6a et 6b de la bascule 16, cet état dépendant de la valeur du signal de réglage délivré au pré-amplificateur 15 qui joue sur les valeurs de pré-amplification de ce dernier. Ainsi, successivement, la charge du condensateur 9 tend vers une valeur finale telle que l'état des sorties 6a et 6b de la bascule 16 tend vers un seuil commun de commutation par inversions successives résultant d'incrémentations et de décrémentations successives de la valeur du signal de réglage.

Au bout d'une durée prédéterminée fixée par le circuit d'horloge 13, fixant la fin de la phase de réglage ou de calage, le circuit d'horloge 13 re-commute le commutateur 14 et l'interrupteur 14a à leurs états initiaux, l'entrée 3 du pré-amplificateur 15 étant à nouveau reliée à la ligne extérieure 5 et l'interrupteur 14a re-passant à l'état ouvert.

La durée de la phase de réglage ou de calage est fixée de telle sorte que le réglage de la charge du condensateur 9, et donc le réglage du seuil de commutation de la bascule 16 correspondant à l'état commuté des entrées 2 et 3 du pré-amplificateur 15, puisse s'exécuter selon une approximation souhaitée.

A la suite de ladite phase de réglage, la valeur finale atteinte de la charge du condensateur 9 subsiste et est appliquée en permanence à l'entrée de réglage 10 du pré-amplificateur 15.

La chaîne de comparaison du comparateur 1, constituées par le pré-amplificateur 15 et la bascule 16, fonctionne alors sous l'effet de la valeur finale atteinte de la charge du condensateur 9, de telle sorte que l'offset de cette chaîne est réduit.

Par ailleurs, la présence du dispositif de réglage 12 n'handicape quasiment pas la consommation intrinsèque de courant du comparateur 1.

La présente invention ne se limite pas aux exemples ci-dessus décrits. Des variantes de réalisation et d'application sont possibles sans sortir du cadre défini par les revendications annexées.

## Revendications

1. Dispositif de réglage ou de calage d'un dispositif électronique (1) présentant au moins une entrée d'au moins un signal d'entrée extérieur et au moins une sortie de signal de sortie, la valeur ou l'état du signal de sortie étant une fonction de la valeur ou de l'état dudit au moins un signal d'entrée, comprenant un circuit (9) à mémoire de la valeur d'un signal de réglage, relié à une entrée de réglage (10) du dispositif électronique ; un circuit d'incrémentation /décrémentation (11) de ladite valeur de réglage stockée dans ledit circuit à mémoire ; et un circuit de commutation (12) pour momentanément commuter ladite au moins une entrée (2, 3) du dispositif électronique (1) à un état prédéterminé et relier ladite sortie (6) du dispositif électronique (1) audit circuit à mémoire (9) via ledit circuit d'incrémentation / décrémentation (11) ; ledit circuit d'incrémentation / décrémentation (11) étant adapté pour régler la valeur dudit signal de réglage de telle sorte que, quand ladite au moins une entrée (2, 3) du dispositif électronique (1) est commutée vers ledit état prédéterminé, la valeur ou l'état dudit signal de sortie tende vers ou atteigne une valeur prédéterminée ou un état prédéterminé, **caractérisé par le fait que** ledit circuit d'incrémentation /décrémentation comprend une pompe de charge (11) dont les éléments opposés (11a, 11b) sont reliés à ladite sortie de signal (6a) du dispositif électronique et à une sortie complémentaire (6b) de cette dernière et dont le point commun (17) est relié à ladite entrée de réglage (10) du dispositif électronique et que ledit circuit à mémoire comprend un condensateur (9) relié d'une part à une masse et d'autre part audit point commun (17) de ladite pompe de charge (11).

2. Dispositif selon la revendication 1, **caractérisé par le fait que** le dispositif électronique (1) présente au moins deux entrées de signaux d'entrée extérieurs et que ledit circuit de commutation (12) est adapté pour commuter lesdites entrées (2, 3) du dispositif électronique (1) à un état prédéterminé l'une par rapport à l'autre.

3. Dispositif selon l'une quelconque des revendications précédentes, **caractérisé par le fait que** le dispositif électronique (1) est un comparateur.

4. Dispositif selon la revendication 3, **caractérisé par le fait que** ledit comparateur comprend un pré-amplificateur (15) suivi d'une bascule (16), ledit signal de réglage étant délivré à une entrée de réglage (10) du pré-amplificateur (15).

5. Procédé de réglage ou de calage d'un dispositif électronique présentant au moins une entrée d'au moins un signal d'entrée extérieur et au moins une sortie de signal de sortie la valeur du signal de sortie étant une fonction de la valeur ou de l'état dudit au moins un signal d'entrée, **caractérisé par le fait qu'**il consiste, pendant au moins une phase de réglage :
à commuter ladite au moins une entrée (2, 3) du dispositif électronique (1) dans un état prédéterminé ;
à régler la valeur d'un signal de réglage du dispositif électronique par l'intermédiaire d'une pompe de charge (11) de telle sorte que la valeur ou l'état dudit signal de sortie tendent vers ou atteignent une valeur prédéterminée ou un état prédéterminé ;
et à mémoriser la valeur réglée dudit signal de réglage, représentée par la charge d'un condensateur ;
et **par le fait qu'**il consiste, après ladite phase de réglage, à soumettre le dispositif électronique à ladite valeur réglée dudit signal de réglage.

6. Procédé selon la revendication 5, le dispositif électronique présentant au moins deux entrées de signaux d'entrée extérieurs, **caractérisé par le fait qu'**il consiste à commuter lesdites entrées (2, 3) du dispositif électronique (1) dans un état prédéterminé l'une par rapport à l'autre.

7. Procédé selon la revendication 6, **caractérisé par le fait qu'**il consiste à court-circuiter lesdites entrées du dispositif électronique et à régler la valeur dudit signal de réglage de telle sorte que la valeur ou l'état dudit signal de sortie tende vers ou atteigne un seuil prédéterminé.

8. Procédé selon l'une des revendications 6 et 7, **caractérisé par le fait qu'**il consiste à court-circuiter lesdites entrées du dispositif électronique et à régler la valeur dudit signal de réglage de telle sorte que la valeur ou l'état dudit signal de sortie tende vers ou atteigne un seuil de commutation.

9. Procédé selon la revendication 7, **caractérisé par le fait que** la charge dudit condensateur est réglée par une pompe de charge dont les éléments opposés sont reliés à ladite sortie de signal (6a) du dispositif électronique et à une sortie complémentaire (6b) de cette dernière

## Claims

1. Device for adjusting or setting an electronic device (1) exhibiting at least one input for at least one external input signal and at least one output signal output, the value or the state of the output signal being a function of the value or of the state of said at least one input signal, comprising a memory circuit (9) for the value of an adjustment signal, linked to an adjustment input (10) of the electronic device; a circuit (11) for incrementing/decrementing said adjustment value stored in said memory circuit; and a switching circuit (12) for momentarily switching said at least one input (2, 3) of the electronic device (1) to a predetermined state and for linking said output (6) of the electronic device (1) to said memory circuit (9) via said incrementing/decrementing circuit (11); said incrementing/decrementing circuit (11) being adapted for adjusting the value of said adjustment signal in such a way that, when said at least one input (2, 3) of the electronic device (1) is switched to said predetermined state, the value or the state of said output signal tends to or attains a predetermined value or a predetermined state, **characterized in that** said incrementing/decrementing circuit comprises a charge pump (11) whose opposite elements (11a, 11b) are linked to said signal output (6a) of the electronic device and to an output (6b) complementary thereto and whose common point (17) is linked to said adjustment input (10) of the electronic device and that said memory circuit comprises a capacitor (9) linked on the one hand to a ground and on the other hand to said common point (17) of said charge pump (11).

2. Device according to Claim 1, **characterized in that** the electronic device (1) exhibits at least two inputs for external input signals and that said switching circuit (12) is adapted for switching said inputs (2, 3) of the electronic device (1) to a predetermined state, one with respect to the other.

3. Device according to any one of the preceding claims, **characterized in that** the electronic device (1) is a comparator.

4. Device according to Claim 3, **characterized in that** said comparator comprises a preamplifier (15) followed by a flip-flop (16), said adjustment signal being delivered to an adjustment input (10) of the preamplifier (15).

5. Method for adjusting or setting an electronic device exhibiting at least one input for at least one external input signal and at least one output signal output, the value of the output signal being a function of the value or of the state of said at least one input signal, **characterized in that** it consists, during at least one adjustment phase:
in switching said at least one input (2, 3) of the electronic device (1) into a predetermined state;
in adjusting the value of an adjustment signal for the electronic device by way of a charge pump (11) in such a way that the value or the state of said output signal tend to or attain a predetermined value or a predetermined state;
and in storing the adjusted value of said adjustment signal, represented by the charge of a capacitor;
and **in that** it consists, after said adjustment phase, in subjecting the electronic device to said adjusted value of said adjustment signal.

6. Method according to Claim 5, the electronic device exhibiting at least two inputs for external input signals, **characterized in that** it consists in switching said inputs (2, 3) of the electronic device (1) into a predetermined state, one with respect to the other.

7. Method according to Claim 6, **characterized in that** it consists in short-circuiting said inputs of the electronic device and in adjusting the value of said adjustment signal in such a way that the value or the state of said output signal tends to or attains a predetermined threshold.

8. Method according to one of Claims 6 and 7, **characterized in that** it consists in short-circuiting said inputs of the electronic device and in adjusting the value of said adjustment signal in such a way that the value or the state of said output signal tends to or attains a switching threshold.

9. Method according to Claim 7, **characterized in that** the charge of said capacitor is adjusted by a charge pump whose opposite elements are linked to said signal output (6a) of the electronic device and to a complementary output (6b) of the latter.

## Patentansprüche

1. Vorrichtung zur Regelung oder Einstellung einer elektronischen Vorrichtung (1), die mindestens einen Eingang mindestens eines äußeren Eingangssignals und mindestens einen Ausgang eines Ausgangssignals hat, wobei der Wert oder der Zustand des Ausgangssignals eine Funktion des Werts oder des Zustands des mindestens einen Eingangssignals ist, die eine Speicherschaltung (9) des Werts eines Regelungssignals, die mit einem Regelungseingang (10) der elektronischen Vorrichtung verbunden ist; eine Inkrementierungs-/Dekrementierungsschaltung (11) des in der Speicherschaltung gespeicherten Regelungswerts; und einen Schaltkreis (12) enthält, um momentan den mindestens einen Eingang (2, 3) der elektronischen Vorrichtung (1) auf einen vorbestimmten Zustand umzuschalten und den Ausgang (6) der elektronischen Vorrichtung (1) über die Inkrementierungs-/Dekrementierungsschaltung (11) mit der Speicherschaltung (9) zu verbinden; wobei die Inkrementierungs-/Dekrementierungsschaltung (11) geeignet ist, um den Wert des Regelungssignal so zu regeln, dass, wenn der mindestens eine Eingang (2, 3) der elektronischen Vorrichtung (1) in den vorbestimmten Zustand umgeschaltet ist, der Wert oder der Zustand des Ausgangssignals zu einem vorbestimmten Wert oder vorbestimmten Zustand tendiert oder ihn erreicht, **dadurch gekennzeichnet, dass** die Inkrementierungs-/Dekrementierungsschaltung eine Ladungspumpe (11) enthält, deren entgegengesetzte Elemente (11a, 11b) mit dem Signalausgang (6a) der elektronischen Vorrichtung und mit einem komplementären Ausgang (6b) zu diesem letzteren verbunden sind, und deren gemeinsamer Punkt (17) mit dem Regelungseingang (10) der elektronischen Vorrichtung verbunden ist, und dass die Speicherschaltung einen Kondensator (9) enthält, der einerseits mit einer Masse und andererseits mit dem gemeinsamen Punkt (17) der Ladungspumpe (11) verbunden ist.

2. Vorrichtung nach Anspruch 1, **dadurch gekennzeichnet, dass** die elektronische Vorrichtung (1) mindestens zwei Eingänge äußerer Eingangssignale aufweist, und dass der Schaltkreis (12) geeignet ist, um die Eingänge (2, 3) der elektronischen Vorrichtung (1) zueinander in einen vorbestimmten Zustand umzuschalten.

3. Vorrichtung nach einem der vorhergehenden Ansprüche, **dadurch gekennzeichnet, dass** die elektronische Vorrichtung (1) ein Komparator ist.

4. Vorrichtung nach Anspruch 3, **dadurch gekennzeichnet, dass** der Komparator einen Vorverstärker (15) gefolgt von einer Kippstufe (16) enthält, wobei das Regelungssignal an einen Regelungseingang (10) des Vorverstärkers (15) geliefert wird.

5. Verfahren zur Regelung oder Einstellung einer elektronischen Vorrichtung, die mindestens einen Eingang mindestens eines äußeren Eingangssignals und mindestens einen Ausgang eines Ausgangssignals hat, wobei der Wert des Ausgangssignals eine Funktion des Werts oder des Zustands des mindestens einen Eingangssignals ist, **dadurch gekennzeichnet, dass** es während mindestens einer Regelungsphase darin besteht:
den mindestens einen Eingang (2, 3) der elektronischen Vorrichtung (1) in einen vorbestimmten Zustand umzuschalten;
den Wert eines Regelungssignals der elektronischen Vorrichtung mittels einer Ladungspumpe (11) zu regeln, so dass der Wert oder der Zustand des Ausgangssignals zu einem vorbestimmten Wert oder einem vorbestimmten Zustand tendiert oder ihn erreicht;
und den geregelten Wert des Regelungssignals zu speichern, der durch die Ladung eines Kondensators dargestellt wird;
und dadurch, dass es nach der Regelungsphase darin besteht, die elektronische Vorrichtung mit dem geregelten Wert des Regelungssignals zu beaufschlagen.

6. Verfahren nach Anspruch 5, wobei die elektronische Vorrichtung mindestens zwei Eingänge von äußeren Eingangssignalen aufweist, **dadurch gekennzeichnet, dass** es darin besteht, die Eingänge (2, 3) der elektronischen Vorrichtung (1) zueinander in einen vorbestimmten Zustand umzuschalten.

7. Verfahren nach Anspruch 6, **dadurch gekennzeichnet, dass** es darin besteht, die Eingänge der elektronischen Vorrichtung kurzzuschließen und den Wert des Regelungssignals so zu regeln, dass der Wert oder der Zustand des Ausgangssignals zu einer vorbestimmten Schwelle tendiert oder sie erreicht.

8. Verfahren nach einem der Ansprüche 6 und 7, **dadurch gekennzeichnet, dass** es darin besteht, die Eingänge der elektronischen Vorrichtung kurzzuschließen und den Wert des Regelungssignals so zu regeln, dass der Wert oder der Zustand des Ausgangssignals zu einer Umschaltschwelle tendiert oder sie erreicht.

9. Verfahren nach Anspruch 7, **dadurch gekennzeichnet, dass** die Ladung des Kondensators von einer Ladungspumpe geregelt wird, deren entgegengesetzte Elemente mit dem Signalausgang (6a) der elektronischen Vorrichtung und mit einem komplementären Ausgang (6b) zu diesem letzteren verbunden sind.
